## Europäisches Patentamt
## European Patent Office
## Office européen des brevets

(19)

(11) Veröffentlichungsnummer : **0 075 295**
**B1**

(12) **EUROPÄISCHE PATENTSCHRIFT**

(45) Veröffentlichungstag der Patentschrift :
30.12.86

(51) Int. Cl.⁴ : **H 04 B 17/00,** H 04 B  9/00

(21) Anmeldenummer : 82108608.9

(22) Anmeldetag : 17.09.82

(54) **Optisches Übertragungssystem für hochfrequente digitale Signale.**

(30) Priorität : 21.09.81 DE 3137497

(43) Veröffentlichungstag der Anmeldung :
30.03.83 Patentblatt 83/13

(45) Bekanntmachung des Hinweises auf die Patenterteilung : 30.12.86 Patentblatt 86/52

(84) Benannte Vertragsstaaten :
AT BE CH DE FR GB IT LI LU NL SE

(56) Entgegenhaltungen :
DE-A- 2 902 789
GB-A- 1 582 726
GB-A- 2 025 121
PATENTS ABSTRACTS OF JAPAN, Band 1, Nr. 135, 9.
November 1977, Seite 6217E77
PATENTS ABSTRACTS OF JAPAN, Band 5, Nr. 74, (E-
57)(746), 16. Mai 1981
5TH EUROPEAN CONFERENCE ON OPTICAL
COMMUNICATIONS, Amsterdam, 17.-19. September
1979, Seiten 22.2-1 - 22.2-4, IEEE, New York, USA. E.
KREMERS et al.: "A 280 Mbit/s fibre optic communication link"

(73) Patentinhaber : **Siemens Aktiengesellschaft Berlin
und München
Wittelsbacherplatz 2
D-8000 München 2 (DE)**

(72) Erfinder : **Keil, Heinrich, Dipl.-Ing.
Beltweg 3
D-8000 München 40 (DE)**
Erfinder : **Trimmel, Herwig, Dipl.-Ing.
Adenauer-Strasse 9
D-8039 Puchheim (DE)**

EP 0 075 295 B1

## Beschreibung

Die Erfindung betrifft ein optisches Übertragungssystem für hochfrequente digitale Signale mit einem Laserdiodensender, der eine Regelung des Laserdiodenvorstroms und/oder des Modulationsstroms durch Umformung eines abgezweigten Teils des von der Laserdiode abgegebenen Nutzlichtes in ein elektrisches Signal enthält, mit einem Empfänger, der ein lichtempfindliches elektrisches Bauelement mit nachgeschaltetem Verstärker und einer Signalverarbeitungseinrichtung enthält, und mit einer Einrichtung zur Übertragung eines zusätzlichen niederfrequenten Signals, in dem dieses einem anderen Signal aufmoduliert wird.

Übertragungssysteme für digitale Signale benötigen in gewissen Abständen in die Übertragungsstrecke eingefügte ferngespeiste Zwischenstellen, in denen eine amplituden- und zeitmäßige Regenerierung der digitalen Signale erfolgt. Bei Verwendung von Koaxialkabeln besteht die Möglichkeit, über das Nachrichtenkabel zusätzlich den Fernspeisestrom und außerdem zusätzliche Signale, beispielsweise von einem Dienstkanal oder von einem Alarm- und Meldekanal, zu übertragen. Bei optischen Übertragungssystemen besteht fallweise die Möglichkeit, derartige zusätzliche Signale über eine zusätzliche Fernspeiseleitung zu übertragen. Im Hinblick auf eine örtliche Speisung von Regeneratoren für das optische Übertragungssystem kann aber der Fall eintreten, daß keine Fernspeiseleitung parallel zur gesamten optischen Übertragungsstrecke vorgesehen ist. In diesem Falle besteht das Bedürfnis nach einem zusätzlichen, gegenüber den digitalen Signalen vergleichsweise niederfrequenten Signalweg, der mit über das optische Übertragungssystem verläuft.

Aus « Electronic Letters » vom 31. Juli 1980, Seiten 624 bis 626, ist ein optisches Übertragungssystem bekannt, bei dem ein zusätzlicher Kanal zur Übertragung von Überwachungsinformation und als Dienstkanal vorgesehen ist. Die Übertragung der zusätzlichen Informationen erfolgt dabei durch direkte Modulation der Bitrate der ausgesendeten Datensignale. Diese Modulation bewirkt eine Erhöhung des Jitters, also der Phasenmodulation der digitalen Signale, die, gegebenenfalls in Verbindung mit weiteren Störeinflüssen, zu Störungen bei der Übertragung der digitalen Signale führen kann.

Aus der DE-A-2 902 789 ist ein Sender für ein optisches Nachrichtenübertragungssystem bekannt, der eine Regelung der verwendeten Lichtquelle durch Umformung eines abgezweigten Teils des abgegebenen Nutzlichtes in ein elektrisches Signal und Vergleich dieses Signal mit einem Referenzwert enthält. Zur Übertragung eines zusätzliches Signals, beispielsweise eines Dienstkanals, kann dem für die Steuerung verwendeten Referenzsignal das zusätzliche Signal überlagert werden, wodurch sich eine entsprechende Schwankung des Lichtquellenvorstroms und damit eine Modulation der Hüllkurve des abgegebenen Lichtes ergibt. Empfangsseitig kann aus der Schwankung der Hüllkurve das zusätzliche Signal wiedergewonnen werden, wobei sich aber eine hohe Empfindlichkeit gegenüber tieffrequenten Störungen ergibt, außerdem ist die Verwendung von PIN-FET-Empfängern hoher Impedanz wegen deren Empfindlichkeit gegenüber tieffrequenten Anteilen im Signalspektrum nicht möglich.

Aus der DE-OS 2 841 433 ist ein Verfahren zur Regelung der Laserdioden zugeführten Vorstroms bekannt, bei dem dem Vorstrom eine periodische Schwingung mit gegenüber dem Übertragungssignal vergleichsweise niedriger Frequenz und geringer Amplitude überlagert wird. Ein Teil des von der Laserdiode abgestrahlten Lichts wird abgezweigt, die periodische Schwingung zurückgewonnen und nach Umformung und Vergleich mit einem Normsignal zur Vorstromregelung herangezogen.

Aus der DE-OS 2 847 182 ist eine der Vorstromregelung entsprechende Regelung des Modulationsstroms von Laserdioden bekannt.

Aus « Electronic Letters » vom 23. November 1978, Seiten 775 und 776 ist eine weitere Schaltungsanordnung zur Regelung des Laserschwellwertes bekannt, bei der ebenfalls dem Laservorstrom und dem zu übertragenden Datensignal mindestens ein niederfrequentes Signal kleiner Amplitude überlagert wird. Auch in diesem Falle wird ein Teil des von der Laserdiode abgestrahlten Lichts von einer Fotodiode aufgenommen, das niederfrequente Signal zurückgewonnen und nach entsprechender Umformung zur Regelung des Laserdiodenvorstroms und zur Regelung des Modulationsstroms verwendet. An eine Übertragung dieser Regelsignale über des optische Übertragungssystem ist beim Stand der Technik, insbesondere im Hinblick auf die sehr geringen Amplituden des Regelsignals, nicht gedacht.

Die Aufgabe der Erfindung besteht also darin, eine Möglichkeit zur Einrichtung eines Überwachungs- oder Dienstkanals zu schaffen, die die zu übertragenden digitalen Signale möglichst wenig beeinflußt und ohne Verwendung zusätzlicher Leitungseinrichtungen auskommt.

Erfindungsgemäß wird die Aufgabe bei einem optischen Übertragungssystem der eingangs erwähnten Art dadurch gelöst, daß dies durch die kennzeichnenden Merkmale des Patentanspruchs 1 weitergebildet wird.

Ein besonderer Vorteil ist dabei, daß die Regeleinrichtungen des Laserdiodensenders zur Übertragung des Zusatzsignals mit herangezogen werden können und deshalb der zusätzlich benötigte Aufwand vergleichsweise sehr gering ist. Dennoch ist die Übertragung des Zusatzsignals von den Regelvorgängen des Laserdiodensenders unabhängig, so daß eine Verfälschung des Zusatzsignals durch Regelabweichungen ausgeschlossen werden kann.

Zweckmäßige Ausbildungen des erfindungsgemäßen optischen Übertragungssystems sind in den Patentansprüchen 2 bis 4 näher beschrieben.

Die Erfindung soll im folgenden anhand der Zeichnung näher erläutert werden. In der Zeichnung zeigt

Figur 1 das Blockschaltbild eines Sendeteils eines optischen Übertragungssystems nach der Erfindung,

Figur 2 ein Impulsdiagramm zur Regelung des Modulationsstroms in der Fig. 1,

Figur 3 ein weiteres Impulsdiagramm zur Fig. 1,

Figur 4 das Blockschaltbild eines optischen Empfängers des optischen Übertragungssystems nach der Erfindung und

Figur 5 ein Impulsdiagramm zur Fig. 4.

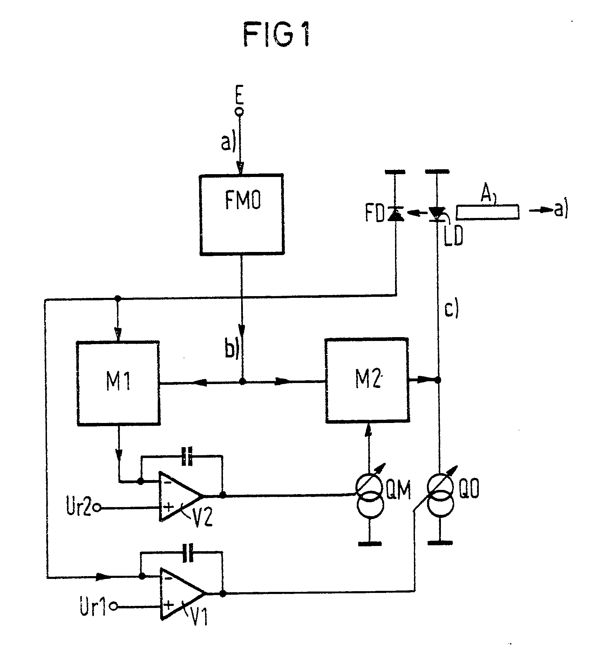

Der in der Fig. 1 dargestellte Lasersender enthält zwei Regelschleifen, die zur Regelung des Modulationsstroms und des Laserdioden-Vorstroms dienen. Zur Bildung der Regelschleifen ist mit der Laserdiode LD zusätzlich zum Lichtwellenleiter A, der den Ausgang des Lasersenders darstellt, eine Fotodiode FD optisch an die Laserdiode angekoppelt. Nach Verstärkung des Fotodiodenausgangssignals in einem in der Zeichnung nicht dargestellten üblichen Verstärker gelangt dieses Signal zum Eingang eines ersten Komparators V1, der nach Art eines Differenzverstärkers aufgebaut ist. Das Ausgangssignal der Fotodiode ist dabei am invertierenden Eingang dieses Verstärkers angelegt, während am nichtinvertierenden Eingang eine erste Referenzspannung Ur1 angeschlossen ist. Invertierender Eingang und Ausgang des Verstärkers sind kapazitiv miteinander verbunden, an den Ausgang ist der Regeleingang einer Quelle Q0 für den Laserdiodenvorstrom angeschlossen. Der Ausgang der Quelle für den Laserdiodenvorstrom ist direkt mit einem Anschluß der Laserdiode LD verbunden.

Durch diese Regelschleife erfolgt eine Regelung der mittleren Lichtleistung der Laserdiode, Abweichungen vom Sollwert werden im Komparator V1 ermittelt und verstärkt und führen den Vorstrom der Laserdiode solange nach, bis der Sollwert erreicht ist.

Zur Regelung des Modulationsstroms ist eine zweite Regelschleife vorgesehen, die ebenfalls an die Fotodiode angeschlossen ist. Zu diesem Zweck ist ein erster Mischer M1 vorgesehen, dessen einer Eingang mit einem Anschluß der Fotodiode FD und dessen anderer Eingang mit einem Anschluß eines Modulators und Oszillators FM0 verbunden ist. Von diesem Oszillator wird eine im Vergleich zu den digitalen Signalen sehr niederfrequente Schwingung erzeugt und an den ersten Mischer M1 sowie an einen Eingang eines zweiten Mischers M2 abgegeben. Mit dem Ausgang des ersten Mischers ist der invertierende Eingang eines zweiten Komparators V2 verbunden, der analog dem ersten Komparator in Form eines Differenzverstärkers aufgebaut ist und an dessen anderer Anschluß eine zweite

Referenzspannung Ur2 gelegt ist. Der Ausgang dieses zweiten Komparators V2 ist mit einem Regeleingang einer Quelle QM für den Modulationsstrom verbunden, deren Ausgang mit einem zweiten Eingang des zweiten Mischers M2 verbunden ist. Der Ausgang dieses zweiten Mischers ist parallel zum Ausgang der Quelle Q0 für den Laserdiodenvorstrom an die Laserdiode geschaltet.

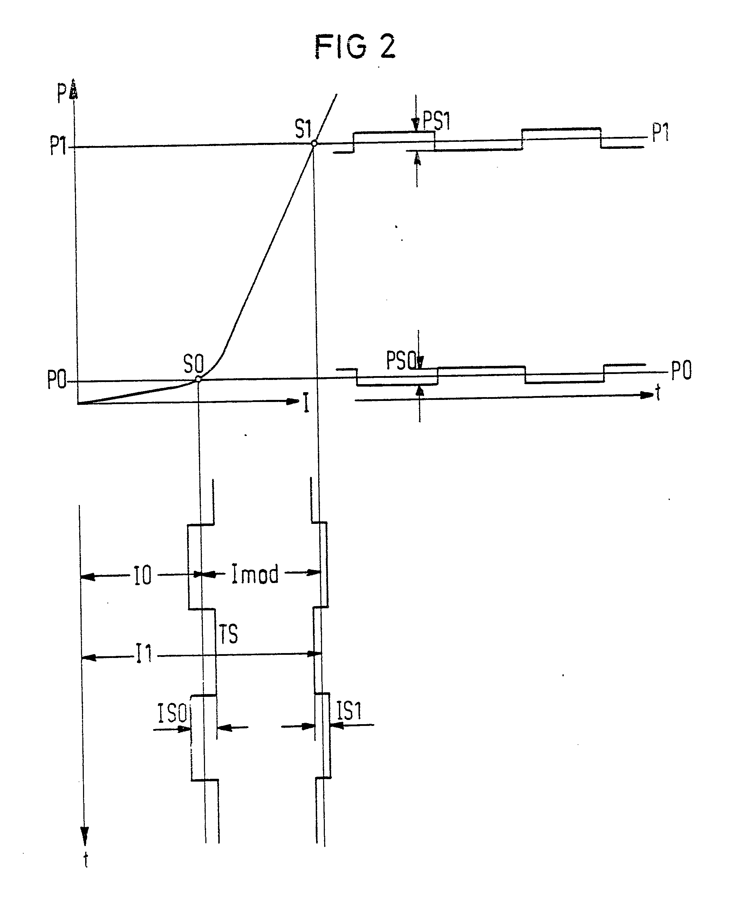

Zur Erläuterung der an sich bekannten Verhältnisse bei der Modulationsstromregelung von Laserdioden mittels eines niederfrequenten Regelsignals kleiner Amplitude dient die Fig. 2.

In der Fig. 2 ist links oben die Kennlinie einer Laserdiode, also die abgegebene Lichtleistung P in Abhängigkeit vom Diodenstrom I, dargestellt. Die untere Begrenzung der Laserdiodenaussteuerung ist durch die Leistung P0 gegeben, die den ersten Knick der Kennlinie markiert, während die obere Begrenzung — etwa der zweite Knick — also die maximal von der Laserdiode abgebbare Lichtleistung im Dauerbetrieb bei P1 liegt. Unter der Kennlinie der Laserdiode sind der Laserdiode zugeführten Ströme dargestellt. Der Laserdiodenvorstrom ist mit 10 und der Laserdiodenmodulationsstrom mit Imod bezeichnet. Aus beiden ergibt sich ein Gesamtstrom I1, dem eine Lichtleistung P1 entspricht.

Zusätzlich sind zwei Regelsignale IS0 und IS1 dargestellt, von denen eines an der Untergrenze und das andere an der Obergrenze dem Modulationsstrom überlagert ist. Die Überlagerung erfolgt im zweiten Modulator M2, die Periode des diesem Modulator zugeführten niederfrequenten Signals Ts bleibt bei der Überlagerung erhalten.

Rechts von der Laserdiodenkennlinie ist die von der Laserdiode abgegebene Lichtleistung dargestellt. Die beiden Teile des Regelsignals ergeben Lichtleistungen PS0 bzw. PS1, die um die Laserdiodenruheleistung P0 bzw. um die maximale Aussteuerung P1 schwanken.

Zur Regelung wird das im Lichtsignal enthaltene Regelsignal über die Fotodiode FD entsprechend Fig. 1 aufgenommen und dem Mischer M1 zugeführt. Dort erfolgt eine Mischung mit dem Ausgangssignal des Modulator-Oszillators FM0, wobei im eingeschwungenen Zustand nur eine Gleichspannung entsteht. Das Ausgangssignal des Mischers M1 wird im zweiten Komparator V2 mit der zweiten Referenzspannung Ur2 verglichen und die entstehende Gleichspannung nach Verstärkung zur Regelung der Quelle QM für den Modulationsstrom verwendet.

Bei Verwendung eines zweiteiligen Regelsignals wird die Differenz PS1 — PS0 zur Regelung verwendet, die Regelung besteht dann darin, daß diese Differenz konstant bleibt.

Zur Vereinfachung kann auf den zweiten Teil Is1 des Regelsignals verzichtet werden. In diesem Falle wird die Amplitude der Lichtleistung PS0 dem zweiten Komparator V2 zugeführt. Die Regelung erfolgt dann so, daß die Lichtleistung PS0 konstant bleibt, da bei zu großer Lichtleistung PS0 der Arbeitspunkt auf einen höheren Wert und bei zu kleiner Lichtleistung PS0 auf einen zu

niedrigen Wert verschoben ist.

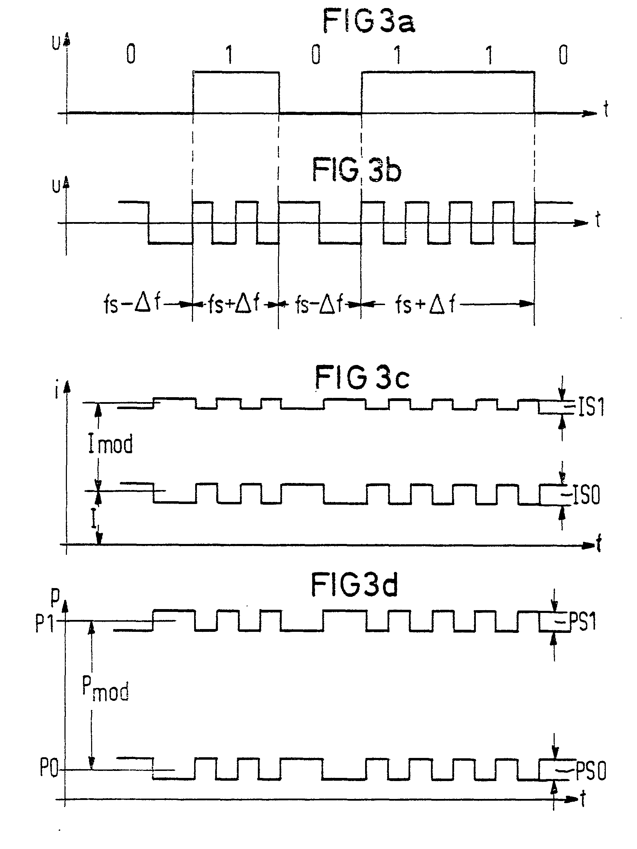

Nach der Darstellung der Regelvorgänge in der Schaltung nach der Fig. 1 sei nun die Wirkungsweise dieser Schaltung in Verbindung mit der Übertragung von Telemetriedaten erläutert. In der Fig. 3a sind diese Telemetriedaten in Form eines 6 Bit-NRZ-PCM-Wortes dargestellt. Nach einer Frequenzmodulation im Frequenzmodulator FM0 ergibt sich ein Signal entsprechend Fig. 3b, die Frequenz fs des NF-Signal entsprechend Fig. 3b, die Frequenz fs des NF-Signals ist also um einen bestimmten Betrag $\Delta f$ erhöht bzw. erniedrigt. Nach Überlagerung dieses Signals zu dem Modulationssignal ergibt sich ein Verlauf entsprechend Fig. 3c, wobei im Hinblick auf die geringere Steilheit der Laserdiodenkennlinie im Punkt S0 der bei S0 wirksame Anteil des Regelsignals eine größere Amplitude als der bei S1 wirksame Anteil erhalten hat, also eine Vorverzerrung zum Steilheitsausgleich vorgenommen wurde.

In der Fig. 3d ist das von der Laserdiode abgegebene Licht P dargestellt, es zeigt sich, daß die beiden Anteile PS1 und PS0 des Regelsignals etwa gleiche Amplitude aufweisen. Nach der Differenzbildung verschwindet dann das Regelsignal, so daß keine Stellgröße zur Veränderung des von der Quelle QM abgegebene Modulationssignals vorhanden ist — die Regelung ist also im eingeschwungenen Zustand. Die Anteile des Regelsignals sind in den Fig. 2 und 3 gegenüber dem Modulationsstrom zur Verdeutlichung vergrößert dargestellt ; in der Praxis ist die Amplitude des Regelsignals wenigstens eine Zehnerpotenz geringer als die des Modulationssignals.

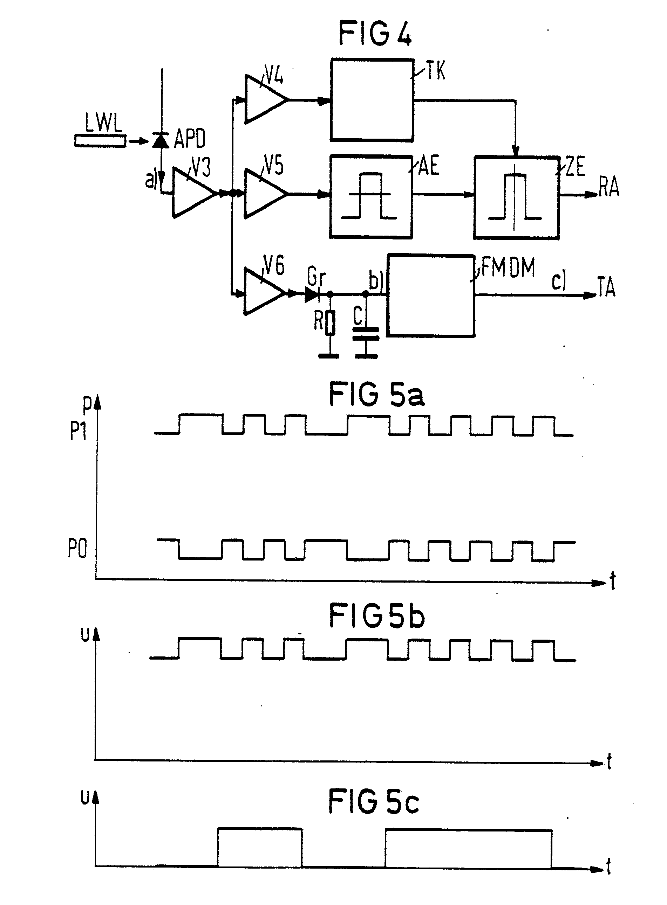

Das von der Laserdiode an die Übertragungsstrecke abgegebene Licht enthält entsprechend Fig. 3d das mit Telemetriedaten modulierte Regelsignal. Von dem in der Fig. 4 dargestellten optischen Empfänger wird am Ende des Lichtwellenleiters von einer Lawinenfotodiode APD das übertragene Licht aufgenommen und in einen entsprechenden elektrischen Strom umgewandelt, der in einem der Fotodiode speziell angepaßten Fotodiodenverstärker V3 verstärkt wird. An den Ausgang dieses Verstärkers sind über Trennverstärker V4, V5, V6 ein Taktkreis TK zur Erzeugung des Bittaktes des übertragenen digitalen Signales ein Impulsregenerator und ein Empfänger für das modulierte Regelsignal angeschlossen. Der Taktkreis TK und der Impulsregenerator mit Amplitudenentscheider AE und Zeitentscheider ZE entsprechen üblichen über Kupferkabel verbundenen Einrichtungen für digitale Signale mit vergleichbarer Bitrate. Der Empfänger für das modulierte Regelsignal enthält eingangsseitig einen Gleichrichter GR und anschließend ein RC-Glied zur Spitzenwertgleichrichtung. Die Zeitkonstante der Spitzenwertgleichrichtung ist dabei so bemessen, daß sie dem niederfrequenten Regelsignal, nicht aber dem höherfrequenten Nutzsignal, folgen kann. An die Gleichrichtung schließt sich ein FM-Demodulator FMDM an, an dessen Ausgang die Telemetriedaten zur weiteren Verarbeitung anstehen.

Im Impulsdiagramm nach der Fig. 5a ist die empfangene Lichtleistung mit den beiden Teilen des modulierten Regelsignals entsprechend Fig. 3d dargestellt. Nach der Spitzenwertgleichrichtung ergibt sich am Kondensator C der in Fig. 5b dargestellte Spannungsverlauf, der das modulierte Regelsignal zusammen mit einem Gleichanteil zeigt. Nach der FM-Demodulation ergibt sich der in Fig. 5c dargestellte Signalverlauf, der dem Telemetriesignal entsprechend Fig. 3a entspricht.

Bei einer weiteren, nicht dargestellten Ausführungsform ist im Empfänger anstelle der Spitzenwertgleichrichtung ein Tiefpaßfilter enthalten. Im Hinblick auf den großen Frequenzabstand zwischen dem Regelsignal und dem Nutzsignal im vorliegenden Falle ist ein derartiges Tiefpaßfilter leicht realisierbar.

**Patentansprüche**

1. Optisches Übertragungssystem für hochfrequente digitale Signale mit einem Laserdiodensender, der eine Regelung des Laserdiodenvorstroms und/oder des Modulationsstroms durch Umformung eines abgezweigten Teils des von der Laserdiode abgegebenen Nutzlichtes in ein elektrisches Signal enthält,

mit einem Empfänger, der ein lichtempfindliches elektrisches Bauelement mit nachgeschaltetem Verstärker und einer Signalverarbeitungseinrichtung enthält,

und mit einer Einrichtung zur Übertragung eines zusätzlichen niederfrequenten Signals, in dem dieses einem anderen Signal aufmoduliert wird,

dadurch gekennzeichnet,

daß die Regelung des Laserdiodenvorstroms und/oder Modulationsstroms in an sich bekannter Weise mittels einer periodischen Schwingung (IS0, IS1) mit einer gegenüber dem Nutzsignal (Imod) vergleichsweise niedrigeren Frequenz und geringeren Amplitude erfolgt, die als Regelsignal dem Vorstrom (I0) überlagert wird,

daß dieses Regelsignal wahlweise einer Frequenzmodulation, einer Winkelmodulation, einer Pulsdauermodulation, einer Pulsphasenmodulation, einer Pulsfrequenzmodulation, einer Phasenumtastung (PSK), einer Pulscodemodulation oder einer Deltamodulation unterworfen wird,

daß das modulierte Regelsignal zusammen mit dem Nutzsignal zum Empfänger übertragen wird,

und daß im Empfänger eine Auskoppelvorrichtung für das Regelsignal des Laserdiodensenders und ein daran angeschlossener Demodulator vorgesehen sind.

2. Optisches Übertragungssystem nach Ansprüchen 1 dadurch gekennzeichnet, daß zur Regelung des Laserdiodenvorstroms eine erste Regelschleife vorgesehen ist, die eine mit der Laserdiode (LD) in optischem Kontakt stehende Fotodiode (FD) enthält, an die ein erster Komparator (V1) angeschlossen ist, dessen Ausgangssignal eine Stromquelle (Q0) für den Laserdiodenvorstrom steuert, daß eine zweite Regelschleife für den Modulationsstrom der Laserdiode vorgesehen ist, die einen Mischer (M1) enthält, dessen einer Eingang mit der Fotodiode (FD) verbunden ist und an dessen Ausgang ein zweiter Komparator (V2) angeschlossen ist, dessen Ausgangssignal eine Quelle (QM) für den Modulationsstrom der Laserdiode (LD) regelt, daß ein Frequenzmodulator (FM0) vorgesehen ist, der einen Oszillator für das zusätzliche niederfrequente Signal und einen Modulator zur Frequenzmodulation dieses zusätzlichen niederfrequenten Signals mit an einem seiner Eingänge anstehenden Datensignalen enthält und dessen Ausgang mit einem zweiten Eingang des Mischers (M1) und mit einem ersten Eingang eines Pilotsignalmodulators (M2) verbunden ist, wobei die Quelle für den Modulationsstrom an einen zweiten Eingang des Pilotsignalmodulators angeschlossen ist und dessen Ausgang mit dem Ausgang der Quelle für den Laserdiodenvorstrom und mit einem Anschluß der Laserdiode verbunden ist.

3. Optisches Übertragungssystem nach Anspruch 1 oder 2, dadurch gekennzeichnet, daß ein optischer Empfänger vorgesehen ist, der eine mit dem Laserdiodensender optisch gekoppelte Fotodiode (APD) enthält, an die ein Fotodiodenverstärker (V3) angeschlossen ist, an dessen Ausgang jeweils über Trennverstärker (V4, V5, V6) ein Taktkreis zur Erzeugung des Bittaktes des übertragenen digitalen Signals, ein Impulsregenerator mit Amplitudenentscheider (AE) und Zeitentscheider (ZE) und ein Empfänger für das zur Regelung des Laserdiodensenders verwendete Signal enthält und letzterer im Anschluß an den Trennverstärker (V6) einen Spitzenwertgleichrichter mit nachgeschaltetem FM-Demodulator enthält.

4. Optisches Übertragungssystem nach Anspruch 3, dadurch gekennzeichnet, daß der Spitzenwertgleichrichter durch ein Tiefpaßfilter ersetzt ist.

## Claims

1. Optical transmission system for high-frequency digital signals having a laser diode transmitter whose preliminary laser diode current and/or the modulation current is controlled by converting a branched component of the useful light emitted by the laser diode into an electrical signal ;
having a receiver which comprises a light-sensitive electrical component with following amplifier and a signal processing device ;
and having a device for the transmission of an additional low-frequency signal modulated onto another signal ;
characterised in that
the control of the preliminary laser diode current and/or modulation current is carried out in known manner by means of a periodical oscillation (IS0, IS1) having a frequency lower than the useful signal (Imod), and a lower amplitude, which is superimposed upon the preliminary current (I0) as a control signal ;
that said control signal is selectively subjected to a frequency modulation, an angle modulation, a pulse duration modulation, a pulse phase modulation, a pulse frequency modulation, a phase switching (PSK), a pulse code modulation or a delta modulation ;
that the modulated control signal together with the useful signal is transmitted to the receiver ; and
that in the receiver an output coupling for the control signal of the laser diode transmitter and associated demodulator are provided.

2. An optical transmission system as claimed in Claim 1, characterised in that to control the preliminary laser diode current there is a first control loop which comprises a photodiode (FD) optically coupled to the laser diode (LD) and to which a first comparator (V1) is connected, whose output signal controls a current source (Q0) for the preliminary laser diode current, that a second control loop is arranged for the modulation current of the laser diode, which comprises a mixer (M1), whose one input is connected to the photodiode (FD) and to whose output a second comparator (V2) is connected, whose output signal controls a source (QM) for the modulation current of the laser diode (LD), that a frequency modulator (FM0) is provided which comprises an oscillator for the additional low-frequency signal and a modulator for the frequency modulation of said additional low-frequency signal by data signals occuring at one of its inputs, and whose output is connected to a second input of the mixer (M1) and to a first input of a pilot signal modulator (M2), where the source for the modulation current is connected to a second input of the pilot signal modulator whose output is connected to the output of the source for the preliminary laser diode current and to a terminal of the laser diode.

3. An optical transmission system as claimed in Claim 1 or 2, characterised in that an optical receiver is provided which comprises a photodiode (APD) optically coupled to the laser diode transmitter, to which is connected a photodiode amplifier (V3) whose output is respectively connected via isolating amplifiers (V4, V5, V6) to a clock pulse circuit for the generation of the bit clock pulse of the transmitted digital signal, a pulse regenerator having an amplitude decision unit (AE) and time decision unit (ZE), and a receiver for the signal used for the control of the laser diode transmitter, the latter comprising a peak value rectifier with a following FM-demodulator connected after the isolating amplifier (V6).

4. An optical transmission system as claimed in Claim 3, characterised in that the peak value rectifier is replaced by a low-pass filter.

## Revendications

1. Système optique de transmission, pour des signaux numériques de haute fréquence, avec un émetteur à diode laser, qui comporte un réglage du courant de prédécharge et/ou du courant de modulation par conversion en un signal électrique d'une partie déviée de la lumière utile émise par la diode laser,

avec un récepteur qui comporte un composant électrique photosensible avec amplificateur aval et avec un dispositif de traitement des signaux, et

avec un dispositif pour la transmission d'un signal supplémentaire basse fréquence, dans lequel celui-ci module un autre signal, caractérisé par le fait,

que le réglage du courant de prédécharge de la diode laser et/ou du courant de modulation est opéré, de façon connue en soi, à l'aide d'une oscillation périodique (IS0, IS1) de fréquence comparativement faible par rapport au signal utile (Imod) et d'amplitude faible, qui est superposée au courant de prédécharge (I0), en tant que signal de réglage,

que ce signal de réglage est soumis, au choix, à une modulation d'impulsions en durée, à une modulation d'impulsions en position, à une modulation d'impulsions en fréquence, à une modulation par impulsions de déphasage (PSK), à une modulation par impulsions codées, ou à une modulation delta,

que le signal de réglage modulé est transmis, avec le signal utile, au récepteur, et

que dans le récepteur est prévu un dispositif de découplage pour le signal de réglage de l'émetteur à diode laser ainsi qu'un démodulateur qui y est relié.

2. Système optique de transmission selon la revendication 1, caractérisé par le fait que pour le réglage du courant de prédécharge de la diode laser, il est prévu une première boucle de régulation qui comporte une photodiode (FD) qui est en contact optique avec la diode laser (LD) et à laquelle photodiode est relié un premier comparateur (V1) dont le signal de sortie commande une source de courant (Q0) pour le courant de prédécharge de la diode laser, qu'il est prévu, pour le courant de modulation de la diode laser, une seconde boucle de réglage qui comporte un mélangeur (M1) dont une entrée est reliée à la photodiode (FD) et à la sortie duquel est relié un second comparateur (V2) dont le signal de sortie règle une source (QM) pour le courant de modulation de la diode laser (LD), qu'il est prévu un modulateur de fréquence (FM0) qui comporte un oscillateur pour le signal supplémentaire basse fréquence et un modulateur pour la modulation en fréquence de ce signal supplémentaire basse fréquence, avec des signaux de données qui sont disponibles à l'une de ses entrées et dont la sortie est reliée à une seconde entrée du mélangeur (M1) et avec une première entrée d'un modulateur de signaux pilote (M2), la source pour le courant de modulation étant reliée à une seconde entrée du modulateur des signaux pilotes et dont la sortie est reliée à la sortie de la source pour le courant de prédécharge de la diode laser et avec une borne de la diode laser.

3. Système optique de transmission selon la revendication 1 ou 2, caractérisé par le fait qu'il est prévu un récepteur optique qui comporte une photodiode (APD) qui est couplée par voie optique à l'émetteur à diode laser, photodiode à laquelle est relié un amplificateur à photodiode (V3) à la sortie duquel et respectivement par l'intermédiaire d'amplificateurs-séparateurs (V4, V5, V6), un circuit de cadence peut produire les cadences de bits des signaux numériques à transmettre, comporte un générateur d'impulsions avec un discriminateur d'amplitude (AE) et un discriminateur du temps (ZE) et un récepteur pour le signal utilisé pour le réglage de l'émetteur à diode laser, alors que ce dernier comporte, après l'amplificateur-séparateur (V6) un redresseur de valeur de pointe avec démodulateur (FM) monté en aval.

4. Système optique de transmission selon la revendication 3, caractérisé par le fait que le redresseur de valeur de crête est remplacé par un filtre passe-bas.

# FIG 1

# FIG 2

# FIG 3a

# FIG 3b

# FIG 3c

# FIG 3d

# FIG 4

# FIG 5a

# FIG 5b

# FIG 5c